# EUROPÄISCHE PATENTSCHRIFT

(11) **EP 2 549 279 B1**
(45) Veröffentlichungstag und Bekanntmachung des Hinweises auf die Patenterteilung: **29.12.2021**
(21) Anmeldenummer: 12005308.7
(22) Anmeldetag: 20.07.2012
(51) Int. Cl.: G01R 19/155

(54) **Vorrichtung und Verfahren zum Prüfen des Vorhandenseins einer elektrischen Spannung**
Device and method for testing the presence of a voltage
Dispositif et procédé de contrôle de la présence d'une tension électrique

(30) Priorität: 21.07.2011 DE 102011108272
(43) Veröffentlichungstag der Anmeldung: 23.01.2013
(73) Patentinhaber: Pfisterer Kontaktsysteme GmbH, 73650 Winterbach (DE)
(72) Erfinder: Jordan, Steffen, 73527 Schwäbisch Gmünd (DE)
(74) Vertreter: Crazzolara, Helmut

(56) Entgegenhaltungen:
- DE-A1- 2 949 941
- DE-A1-102005 001 179
- DE-B- 1 296 255
- US-A- 3 582 675
- US-A1- 2005 105 310
- US-A1- 2009 319 210

## Beschreibung

Die Erfindung betrifft eine Vorrichtung und ein Verfahren zum Prüfen des Vorhandenseins einer elektrischen Spannung an einem möglicherweise spannungsführenden Teil einer elektrischen Anlage, insbesondere einen einpoligen Spannungsprüfer für Mittelspannungs- und/oder Hochspannungs-Energieversorgungsnetze und zugehörige Anlagen, Armaturen und Geräte sowie ein Arbeitsverfahren für einen solchen Spannungsprüfer.

In Energieversorgungsanlagen muss im Rahmen des Personen- und Anlagenschutzes beispielsweise bei Wartungsarbeiten sichergestellt sein, dass die Anlage tatsächlich spannungsfrei ist und dementsprechend an der Arbeitsstelle geerdet werden kann. Die Spannungsfreiheit wird in Wechselspannungsanlagen über 1 kV Betriebsspannung beispielsweise mittels einpoligen kapazitiven Spannungsprüfern festgestellt, deren Bauform und Funktion in der Norm IEC 61243-1 festgelegt ist. Daneben sind für diese Anwendung auch sogenannte Spannungsfernprüfer bekannt, wie sie beispielsweise in der DE 79 10 822 U1 oder der DE 35 27 021 C1 beschrieben sind.

In Gleichstromanlagen über 1,5 kV sind für den Zweck der Spannungsprüfung zweipolige Spannungsprüfer bekannt. Diese bieten grundsätzlich eine sichere Betriebsweise, erfordern jedoch eine erhöhte Sorgfalt bei der Anwendung, da durch die Verbindungsleitung zu dem zweiten Pol bei der Benutzung ein potentieller Kurzschlusspfad gegeben sein kann, der bei einem Geräteversagen Hochspannung und Erde überbrücken und dadurch einen energiereichen Lichtbogen zünden kann, der den Benutzer des Gerätes gefährden und die Anlage zerstören würde.

Aus der DE 1 296 255 ist ein Spannungsprüfer für Gleich- oder Wechselspannung mit einem steuerbaren elektronischen Schaltelement bekannt. Ein Anlegekontakt des Spannungsprüfers wird in Verbindung mit einem spannungsführenden Teil gebracht, und der nach Herstellen der Verbindung fließende Ableitstrom führt nach einigen Sekunden zum Auslösen eines spannungsabhängigen Schalters, der einen Thyristor durchschaltet. Für eine DC-Spannungsprüfung muss eine galvanische Ankopplung benutzt werden, d.h. der Spannungsprüfer arbeitet bei Gleichspannung zweipolig.

Aus der FR 2 881 526 B1 ist ein Verfahren bekannt, mit dem die Vorteile der einpoligen Gerätebauart auch auf Gleichspannungsanwendungen übertragen wird. Dabei werden im elektrostatischen bzw. quasistatischen Feld zwischen zwei benachbarten und durch einen Isolierstoff getrennten Elektroden gezielt Entladungen erzeugt, gemessen und einem Spannungswert zugeordnet.

Die DE 10 2005 001 179 A1 und die US 2009/0319210 A1 offenbaren weitere Spannungsprüfer.

Der Erfindung liegt die Aufgabe zugrunde, eine gattungsgemäße Vorrichtung sowie ein zugehöriges Arbeitsverfahren bereitzustellen, mit dem mit noch weiter erhöhter Zuverlässigkeit das Vorhandensein einer elektrischen Spannung geprüft werden kann. Erfindungsgemäß ist mit einem einpoligen Spannungsprüfer auch das Vorhandensein einer Gleichspannung prüfbar. Erfindungsgemäß ist mit dem Spannungsprüfer das Vorhandensein sowohl einer Gleichspannung als auch einer Wechselspannung prüfbar. In einer weiteren Ausführungsart soll das Vorhandensein einer Gleich- und/oder Wechselspannung in verschiedenen elektrischen Anlagen mit unterschiedlichen Nennspannungen prüfbar sein.

Diese Aufgabe ist durch die im Anspruch 1 bestimmte Vorrichtung sowie durch das im nebengeordneten Anspruch 6 bestimmte Verfahren gelöst. Besondere Ausführungsarten der Erfindung sind in den Unteransprüchen bestimmt.

Gemäß dem Kennzeichen des Anspruchs 1 zeichnet sich die erfindungsgemäße Vorrichtung dadurch aus, dass die Vorrichtung als einpoliger Spannungsprüfer ausgebildet ist, insbesondere für Mittelspannungs- und/oder Hochspannungs-Energieversorgungsnetze, und dadurch erkennt, ob an dem zu prüfenden Teil Gleichspannung oder Wechselspannung anliegt, dass mittels einer Auswerteeinrichtung das Ausgangssignal der Integratoreinrichtung ausgewertet wird und durch Vergleich mit einem Schwellenwert entschieden wird, ob das zu prüfende Teil spannungsführend ist, dass in der Auswerteeinrichtung der Vorrichtung mindestens ein erster Schwellenwert für eine an dem zu prüfenden Teil anliegende Gleichspannung hinterlegt ist und mindestens ein zweiter Schwellenwert für eine an dem zu prüfenden Teil anliegende Wechselspannung hinterlegt ist, und dass die Auswerteeinrichtung unterschiedliche Schwellenwerte berücksichtigt, je nachdem ob eine Gleichspannung oder eine Wechselspannung an dem zu prüfenden Teil anliegt.

Die Integratoreinrichtung oder der Ladungsdetektor können dabei sowohl positive als auch negative Spannungen des zu prüfenden Teils erkennen und sogar unterscheiden. Dadurch können mit einem einzigen Spannungsprüfer sowohl Gleichspannungen (DC) als auch Wechselspannungen (AC) erkannt werden. Dadurch ist die Sicherheit bei der Anwendung einer solchen Vorrichtung erhöht, da bisher beispielsweise in der Eisenbahntechnik die Gefahr besteht, dass ein zweipoliger DC-Spannungsprüfer versehentlich an einer unter Hochspannung stehenden AC-Leitung eingesetzt wird, was mit einer Gefährdung insbesondere der Bedienperson verbunden ist.

Ein weiterer Vorteil des Integrierens besteht darin, dass die Prüfung auf Gleichspannung unabhängig von der Geschwindigkeit des Annäherns bzw. Kontaktierens, allgemein des "Auf-Potenzial-Bringens" oder "Ins-elektrische-Feld-Führen" der Vorrichtung durch den Benutzer, durchführbar ist, insbesondere ermittelbar ist, ob das zu prüfende Teil unter Spannung steht oder nicht.

Das Ausgangssignal der Integratoreinrichtung wird durch eine Auswerteeinrichtung dahingehend ausgewertet, ob ein vorgegebener Schwellenwert erreicht wurde. Ein Erreichen oder Überschreiten des Schwellenwerts wird dahingehend interpretiert, dass das zu prüfende Teil spannungsführend ist.

Die Vorrichtung weist eine Integratoreinrichtung auf, die das elektrische Signal integriert, das sich durch das In-Anlage-Bringen der Kontaktelektrode und/oder durch das Annähern der Koppelelektrode an das möglicherweise spannungsführende Teil der zu prüfenden elektrischen Anlage verändert. So ändert sich beispielsweise das elektrische Potenzial der Koppelelektrode oder der Kontaktelektrode beim Annähern der Koppelelektrode bzw. beim In-Anlage-Bringen der Kontaktelektrode und diese Änderung des elektrischen Potenzials wird mittels der Integratoreinrichtung aufintegriert. Anschließend wird der Integrationswert dahingehend ausgewertet, ob das zu prüfende Teil spannungsführend ist oder nicht.

In einer Ausführungsart weist die Integratoreinrichtung einen Ladungsdetektor auf, insbesondere bildet der Ladungsdetektor die Eingangsschaltung der Vorrichtung. Bei einem Annähern der Koppelelektrode oder in In-Anlage-Bringen der Kontaktelektrode fließt innerhalb des Ladungsdetektors ein vorzugsweise impulsförmiger Ausgleichsstrom in einen Ladungsspeicher, der durch einen Kondensator gebildet sein kann. Der Ausgleichsstrom fließt insbesondere bei anliegender Gleichspannung nur einmalig und kurzzeitig, insbesondere sobald die Kontaktelektrode in Anlage an das spannungsführende Teil kommt.

Der bei Gleichspannung nur kurzzeitige und einmal fließende Ausgleichsstrom zwischen dem spannungsführenden zu prüfenden Teil der Anlage und der erfindungsgemäßen Vorrichtung wird zur Spannungsprüfung benutzt. Dieser Ladestrom ist proportional zur anliegenden Spannung. Damit kann eindeutig ermittelt werden, ob die Anlage bzw. das zu prüfende Anlagenteil als spannungsfrei zu betrachten ist, weil allenfalls eine erlaubte maximale Restspannung vorhanden ist, oder ob die Anlage bzw. das zu prüfende Anlagenteil als spannungsführend zu betrachten ist, weil die ermittelte Spannung den zugeordneten Schwellenwert überschreitet.

In einer Ausführungsart bleibt eine Anzeige der Vorrichtung auf "spannungsführend" oder "Spannung vorhanden", auch wenn das Ausgangssignal der Integratoreinrichtung wieder unter den Schwellenwert absinkt. Dadurch ist es möglich, die Vorrichtung sowohl zur Prüfung auf Gleichspannung als auch zur Prüfung auf Wechselspannung einzusetzen. Außerdem erzwingt das Aufrechterhalten der Anzeige "Spannung vorhanden" ein Rücksetzen der Integratoreinrichtung vor einem erneuten Prüfvorgang mit der Vorrichtung, insbesondere ein Entladen des Ladungsdetektors der Integrationseinrichtung.

In einer Ausführungsart weist die Vorrichtung einen Mikrocontroller auf, der ein abgespeichertes Programm abarbeitet. Der Schwellenwert ist vorzugsweise als Datenwert in einem Speicher der Steuerung abgelegt. In einer Ausführungsart können auch mehrere Schwellenwerte abgelegt sein, insbesondere unterschiedliche Schwellenwerte je nachdem, ob die Vorrichtung eine Gleichspannung erkennt oder eine Wechselspannung erkennt.

Die Vorrichtung umfasst auch eine Anzeigeeinrichtung, mittels der die Spannungsfreiheit und/oder das Ermitteln einer Spannungsführung signalisierbar ist. Die Anzeigeeinrichtung kann beispielsweise Leuchtdioden aufweisen, vorzugsweise hoher Leuchtintensität und/oder mit einem gebündelten Abstrahlwinkel von beispielsweise weniger als 90°, insbesondere weniger als 60°, so dass auch beispielsweise unter hellen Tageslichtbedingungen ein eindeutiges Ablesen der Anzeigeeinrichtung möglich ist. Alternativ oder ergänzend kann die Anzeigeeinrichtung auch weitere Signalmittel aufweisen, beispielsweise Signalmittel für ein akustisches und/oder haptisches Signalisieren, etwa durch ein Vibrieren des Handgriffes der Vorrichtung.

In einer Ausführungsart weist die Vorrichtung Schaltungselemente zum Rücksetzen der Vorrichtung auf, insbesondere zum Entladen eines Ladungsdetektors der Integratoreinrichtung. Das Rücksetzen kann beispielsweise vor jeder Inbetriebnahme der Vorrichtung erforderlich sein, insbesondere kann die Vorrichtung so ausgelegt sein, dass sie ohne Rücksetzen nicht betriebsbereit ist. Das Rücksetzen kann beim Einschalten der Vorrichtung automatisch erfolgen. Das Rücksetzen kann auch manuell gestartet werden, beispielsweise durch Betätigen einer entsprechenden Rücksetztaste an der Vorrichtung.

Beispielsweise wird der Kondensator des Ladungsdetektors automatisch bei einer Inbetriebnahme der Vorrichtung entladen oder im bereits eingeschalteten Zustand manuell gesteuert entladen, wobei die Vorrichtung hierzu auf Erdpotenzial gelegt wird, beispielsweise indem die Kontaktelektrode in Anlage an eine geerdete Elektrode gebracht wird. Anschließend kann die Vorrichtung an das zu prüfende Teil gebracht werden, wobei der auftretende Ladeimpuls gespeichert wird und gegebenenfalls von der Auswerteeinrichtung über die Anzeigeeinrichtung signalisiert wird, dass das zu prüfende Teil unter Spannung steht.

In einer Ausführungsart weisen die Schaltungselemente zum Rücksetzen der Vorrichtung ein steuerbares Schaltelement auf, mit dem der Eingang der Integratoreinrichtung, insbesondere der Eingang des Ladungsdetektors der Integratoreinrichtung, temporär mit einem von der Vorrichtung bereitgestellten elektrischen Signal verbunden wird. Beispielsweise kann die Auswerteeinrichtung ein solches Signal bereitstellen. Dieses Signal kann beispielsweise zunächst ansteigen bis zu einem vorgegebenen Maximalwert und anschließend wieder abfallen bis auf Null oder einen kleinen Wert, um auf diese Weise den Kondensator des Ladungsdetektors sicher zu entladen. Das steuerbare Schaltelement ist dabei vorzugsweise durch ein galvanisch schaltendes Schaltelement gebildet, das im geschlossenen Zustand einen geringen Durchgangswiderstand aufweist und vor allem im geöffneten Zustand die Verbindung des Ladungsdetektors mit dem Entladesignal der Auswerteeinrichtung galvanisch und damit sehr hochohmig trennt.

In einer Ausführungsart ist das Rücksetzen der Vorrichtung vor jeder neuen Prüfung auf Spannungsfreiheit zwingend erforderlich, insbesondere ein Entladen des Ladungsdetektors der Integratoreinrichtung. Sofern die Prüfung ergeben hat, dass das zu prüfende Teil spannungsführend ist, und die Anzeigeeinrichtung dieses Ergebnis signalisiert, wird das entsprechende Signal der Anzeigeeinrichtung aufrechterhalten, auch wenn der Ladungsdetektor nach Entfernen der Vorrichtung vom spannungsführenden Teil entladen oder sogar auf ein umgekehrtes Potenzial umgeladen wird. Erst durch ein Rücksetzen ist die Vorrichtung für eine erneute Prüfung einsatzbereit. Dadurch werden Fehlanzeigen der Vorrichtung zuverlässig verhindert, die beispielsweise auftreten könnten, wenn nacheinander zunächst an einer höheren Spannung und dann an einer niederen Spannung gemessen wird.

In einer Ausführungsart signalisiert die Vorrichtung auch den Betriebszustand, in dem die Vorrichtung rückgesetzt ist. Die Bereitschaftszeit der Vorrichtung nach dem Rücksetzen ist in der Praxis begrenzt durch nicht vollständig zu unterbindende Leckströme der Eingangsschaltung, so dass nach einer von den Umständen abhängigen Zeitdauer ein erneutes Rücksetzen der Vorrichtung durchgeführt werden muss. Dieses erforderliche erneute Rücksetzen kann von der Einrichtung signalisiert werden, beispielsweise durch Erlöschen des Signalmittels, welches den zurückgesetzten Zustand der Vorrichtung signalisiert. Alternativ oder ergänzend kann sich die Vorrichtung auch nach einer vorgegebenen Zeitdauer automatisch abschalten. Beim Wiedereinschalten der Vorrichtung ist zwingend eine erneute Rücksetzung erforderlich, bevor eine Prüfung durchgeführt werden kann.

Nach einem Rücksetzen mit Hilfe des nochmaligen ansteigenden und anschließend abfallenden Steuersignals kann die ordnungsgemäße Trennung eines steuerbaren Schaltelements überprüft werden.

Die Koppelelektrode ist nicht zwingend in Anlage an das zu prüfende Teil zu bringen, sondern kapazitiv und daher ohne unmittelbaren physischen Kontakt an das zu prüfende Teil ankoppeln kann. Die Vorrichtung kann auch optionale Verlängerungen der Kontaktelektrode oder der Koppelelektrode aufweisen, beispielsweise um dadurch die Selektivität gegenüber Streufeldern zu erhöhen.

Weitere Vorteile, Merkmale und Einzelheiten der Erfindung ergeben sich aus den Unteransprüchen und der nachfolgenden Beschreibung, in der unter Bezugnahme auf die Zeichnungen ein Ausführungsbeispiel im Einzelnen beschrieben ist.
- Fig. 1: zeigt eine Seitenansicht auf ein Ausführungsbeispiel einer erfindungsgemäßen Vorrichtung;
- Fig. 2: zeigt eine perspektivische Ansicht auf die dem Anwender zugewandte Unterseite eines Anzeigegerätes der Vorrichtung; und
- Fig. 3: zeigt schematisiert den schaltungstechnischen Aufbau eines Ausführungsbeispiels der Vorrichtung.

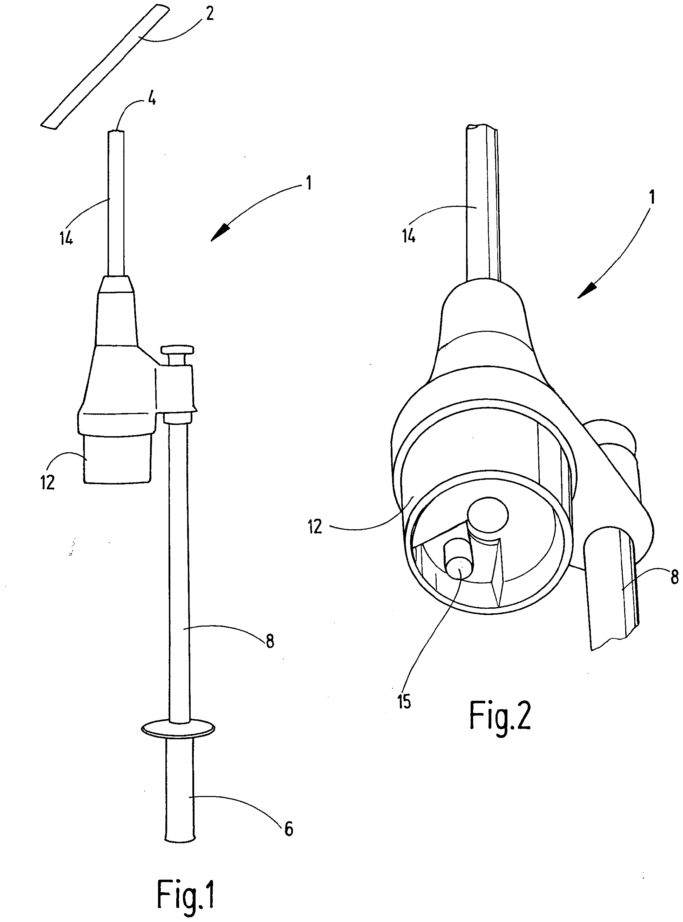

Die Fig. 1 zeigt eine Seitenansicht auf ein Ausführungsbeispiel einer erfindungsgemäßen Vorrichtung 1 zum Prüfen des Vorhandenseins einer elektrischen Spannung an einem möglicherweise spannungsführenden Teil 2 einer elektrischen Anlage. Im Ausführungsbeispiel handelt es sich um einen Spannungsprüfer für Anlagen und Netze zur elektrischen Energieversorgung mit Mittel- und Hochspannung. Die Nennspannungen liegen beispielsweise bei 500 V bis 1.000 kV, insbesondere bei 1 kV bis 300 kV. Die Vorrichtung 1 weist eine Kontaktelektrode 4 auf, die an das zu prüfende Teil 2 in Anlage bringbar ist. Alternativ oder ergänzend kann die Vorrichtung 1 auch eine insbesondere kapazitive Koppelelektrode aufweisen, die an das zu prüfende Teil 2 annäherbar ist, insbesondere nicht zwingend in Anlage an das zu prüfende Teil 2 zu bringen ist.

Die Vorrichtung 1 weist einen elektrisch isolierenden Handgriff 6 auf. An oder nahe einem dem Handgriff 6 gegenüberliegenden Ende einer stabförmigen Verlängerung 8, bei der es sich im Ausführungsbeispiel um eine Isolierstange handelt, ist ein Anzeigegerät 12 angeordnet, in dem die Elektronik der Vorrichtung 1 untergebracht ist. Von dem Anzeigegerät 12 erstreckt sich ein Stab 14, an dessen dem Anzeigegerät 12 gegenüberliegenden Ende die Kontaktelektrode 4 angeordnet ist. Es sind auch Ausführungsarten der Erfindung ohne einen solchen Stab 14 möglich, insbesondere solche, bei denen die Kontaktelektrode 4 oder eine Koppelelektrode in unmittelbarer Nähe zu dem Anzeigegerät 12 angeordnet ist. Die Länge des Stabes 8 ist auf den Spannungsbereich des zu prüfenden Teils 2 abgestimmt. Die stabförmige Verlängerung 8 zwischen Anzeigegerät 12 und Handgriff 6 kann in der Art eines Baukastens gegen Stäbe anderer Längen für die Spannungsprüfung an Leitern in anderen Spannungsbereichen ausgetauscht werden. Unterschiedliche Längen des Stabes 14 erhöhen bei Bedarf die Selektivität der Spannungsanzeige abhängig von der elektrischen Feldstärke und des Feldstärkeverlaufes an dem zu prüfenden spannungsführenden Teil 2, seiner Bauform und/oder seiner Lage zu anderen möglicherweise spannungsführenden Teil der elektrischen Anlage.

Die Fig. 2 zeigt eine perspektivische Ansicht auf die dem Anwender zugewandte Unterseite des Anzeigegerätes 12 der Vorrichtung 1. Das Anzeigegerät 12 ist auf der dem Anwender zugewandten Unterseite mindestens teilweise transparent, so dass ein innerhalb des Anzeigegerätes 12 angeordnetes Leuchtmittel, beispielsweise eine Leuchtdiode, durch die Gehäuseabdeckung hindurchstrahlen kann. Auf der dem Anwender zugewandten Unterseite des Anzeigegerätes 12 ist eine Betätigungstaste 15 angeordnet, mittels der die Vorrichtung manuell rücksetzbar ist.

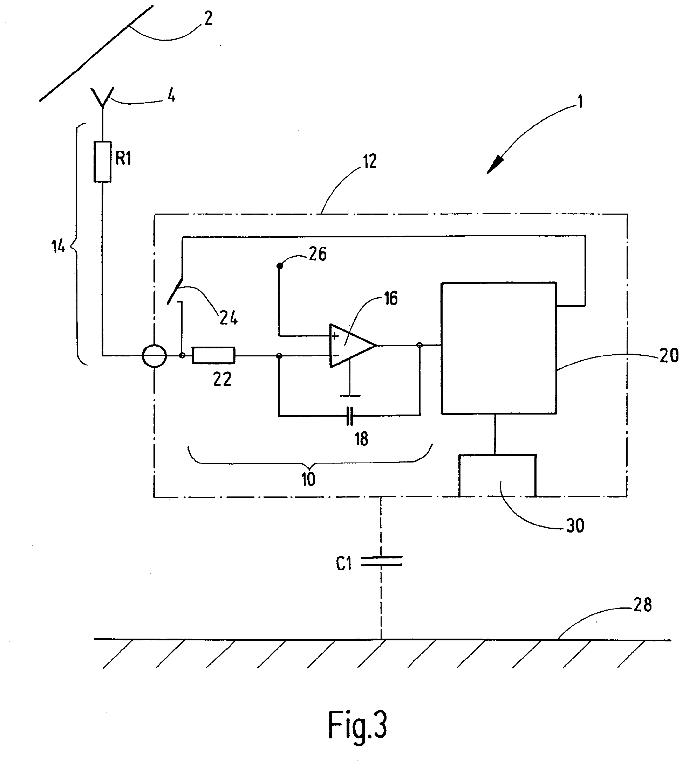

Die Fig. 3 zeigt schematisiert den schaltungstechnischen Aufbau eines Ausführungsbeispiels der Vorrichtung 1. Die Vorrichtung 1 weist eine Integratoreinrichtung 10 auf zum Integrieren des sich durch das Inanlagebringen der Kontaktelektrode 4 an dem zu prüfenden Teil 2 verändernde elektrische Signal. Die in diesem Ausführungsbeispiel V-förmige Kontaktelektrode 4 ist mittels des Stabes 14 elektrisch mit einem Eingang der Integratoreinrichtung 10 verbunden, wobei dieser Eingang isoliert durch das Anzeigegerät 12 hindurchgeführt ist. In dem Stab können abhängig von dem zu prüfenden Spannungsniveau ein oder mehrere Vorwiderstände R1 angeordnet sein. Der Widerstandswert des Vorwiderstandes R1 kann beispielsweise zwischen 50 MΩ und 5.000 MΩ betragen, insbesondere zwischen 100 und 2.000 MΩ und vorzugsweise zwischen 200 und 1.000 MΩ.

Die Integratoreinrichtung arbeitet als Ladungsdetektor, der im Ausführungsbeispiel einen Operationsverstärker 16 umfasst, dessen Ausgang mit dem invertierenden Eingang über einen durch einen Kondensator gebildeten Ladungsspeicher 18 verbunden ist. Am nicht invertierenden Eingang des Operationsverstärkers 16 liegt ein Referenzsignal 26 an, das auch von der Auswerteeinrichtung 20 bereitgestellt werden kann. Die Integratoreinrichtung 10 weist einen an dem invertierenden Eingang des Operationsverstärkers 16 angeschlossenen Widerstand 22 auf, dessen Wert beispielsweise zwischen 100 kΩ und 100 MΩ liegen kann, insbesondere zwischen 200 kΩ und 50 MΩ und vorzugsweise zwischen 500 kΩ und 20 MΩ. Der Kondensator 18 kann beispielsweise einen Wert zwischen 1 nF und 1 *µ*F aufweisen, insbesondere zwischen 2 nF und 800 nF und vorzugsweise zwischen 5 nF und 500 nF.

Der Wert des Kondensators 18 bestimmt im Wesentlichen die Ansprechspannung der Vorrichtung 1 und wird abhängig von der Nennspannung der zu prüfenden Anlage gewählt. Die Integrationszeitkonstante wird überwiegend vom Widerstand R1 bestimmt, wohingegen der Widerstand 22 hauptsächlich für einen nachfolgend noch beschriebenen Eigentest der Vorrichtung 1 eingesetzt ist und/oder für eine Verbesserung der Störfestigkeit gegenüber hochfrequenten Störungen. Die Integrationszeitkonstante ist deutlich kleiner als die bei bestimmungsgemäßem und üblichem Gebrauch der Vorrichtung 1 auftretende Annäherungszeit der Vorrichtung 1, insbesondere der Kontaktelektrode 4, an das spannungsführende Teil 2.

Innerhalb des Anzeigegerätes 12 ist an dem Widerstand 22 ein steuerbares Schaltelement 24 angeschlossen, mittels dem der Eingang der Integratoreinrichtung, insbesondere der Eingang des Ladungsdetektors der Integratoreinrichtung 10, jedenfalls temporär mit der Auswerteeinrichtung 20 elektrisch verbindbar ist. Wenn das Schaltelement 24 geschlossen ist, wird die Vorrichtung 1 zurückgesetzt, insbesondere der Ladungsdetektor der Integratoreinrichtung 10 entladen. Hierzu stellt die Auswerteeinrichtung 20 ein Signal bereit, bei dem die Spannung zunächst auf einen Maximalwert hochgefahren wird und anschließend wieder auf null abgesenkt wird. Dieser Zyklus wird mindestens einmal durchlaufen, bevor die Vorrichtung 1 Betriebsbereitschaft signalisiert. In einer Ausführungsart wird dieser Zyklus mehrfach durchlaufen, insbesondere zweifach oder dreifach. Dadurch ist gewährleistet, dass unabhängig vom Zustand der Integratoreinrichtung 10 der Ladungsspeicher 18 entladen wird. Das Schaltelement 24 ist beispielsweise ein Reed-Relais oder ein sonstiges galvanisch schaltendes und insbesondere galvanisch trennendes Schaltelement.

Bei einer Eigenprüfung der Vorrichtung 1 zum Feststellen der Funktionssicherheit bei der Inbetriebnahme wird unter anderem der Wert des Kondensators 18 über den Widerstand 22 geprüft, indem mittels der Auswerteeinrichtung 20 die Sprungantwort der Integrationseinrichtung 10 auf ein Testsignal, insbesondere ein rechteckförmiges Testsignal, ausgewertet wird.

Innerhalb des Anzeigegerätes 12 bilden die Massefläche der Leiterplatte und die Batterien eine Streukapazität C1 zur Erde 28 der elektrischen Anlage. Die Auswerteeinrichtung 20 ist mit einer Anzeigeeinrichtung 30 der Vorrichtung 1 verbunden, die nach außerhalb des Anzeigegerätes 12 das Ergebnis der Prüfung signalisiert, insbesondere signalisiert, ob das zu prüfende Teil 2 spannungsführend ist oder nicht.

## Patentansprüche

1. Vorrichtung (1) zum Prüfen des Vorhandenseins einer elektrischen Gleichspannung als auch einer elektrischen Wechselspannung an einem möglicherweise spannungsführenden Teil (2) einer elektrischen Anlage, mit einer Kontaktelektrode (4), die an das zu prüfende Teil (2) in Anlage bringbar ist, oder einer Koppelelektrode, die an das zu prüfende Teil annäherbar ist, wobei die Vorrichtung (1) eine Integratoreinrichtung (10) aufweist zum Integrieren des durch das In-Anlage-Bringen der Kontaktelektrode (4) oder durch das Annähern der Koppelelektrode sich verändernden elektrischen Signals, und wobei die Integratoreinrichtung (10) als Ladungsdetektor arbeitet, bei dem ein beim In-Anlage-Bringen der Kontaktelektrode (4) oder beim Annähern der Koppelelektrode fließender Ausgleichsstrom in einem Ladungsspeicher (18) speicherbar ist, **dadurch gekennzeichnet, dass** die Vorrichtung (1) als einpoliger Spannungsprüfer ausgebildet ist, insbesondere für Mittelspannungs- und/oder Hochspannungs-Energieversorgungsnetze, und dadurch erkennt, ob an dem zu prüfenden Teil (2) Gleichspannung oder Wechselspannung anliegt, dass mittels einer Auswerteeinrichtung (20) das Ausgangssignal der Integratoreinrichtung (10) ausgewertet wird und durch Vergleich mit einem Schwellenwert entschieden wird, ob das zu prüfende Teil (2) spannungsführend ist, dass in der Auswerteeinrichtung (20) der Vorrichtung (1) mindestens ein erster Schwellenwert für eine an dem zu prüfenden Teil (2) anliegende Gleichspannung hinterlegt ist und mindestens ein zweiter Schwellenwert für eine an dem zu prüfenden Teil (2) anliegende Wechselspannung hinterlegt ist, und dass die Auswerteeinrichtung (20) unterschiedliche Schwellenwerte berücksichtigt, je nachdem ob eine Gleichspannung oder eine Wechselspannung an dem zu prüfenden Teil (2) anliegt.

2. Vorrichtung (1) nach Anspruch 1, **dadurch gekennzeichnet, dass** die Integratoreinrichtung (10) einen Operationsverstärker (16) in Integratorschaltung aufweist, mit einem einen Ausgang mit einem Eingang des Operationsverstärkers (16) verbindenden Ladungsspeicher (18), der den beim In-Anlage-Bringen der Kontaktelektrode (4) oder beim Annähern der Koppelelektrode fließenden Strom speichert.

3. Vorrichtung (1) nach Anspruch 1 oder 2, **dadurch gekennzeichnet, dass** nach einer Entscheidung der Auswerteeinrichtung (20), dass das zu prüfende Teil (2) spannungsführend ist, vor einer erneuten Prüfung ein Rücksetzen der Integratoreinrichtung (10) erforderlich ist, insbesondere ein Entladen eines Ladungsdetektors der Integratoreinrichtung (10).

4. Vorrichtung (1) nach einem der Ansprüche 1 bis 3, **dadurch gekennzeichnet, dass** die Vorrichtung (1) Schaltungselemente zum Rücksetzen der Vorrichtung (1) aufweist, insbesondere zum Entladen eines Ladungsdetektors der Integratoreinrichtung (10).

5. Vorrichtung (1) nach Anspruch 4, **dadurch gekennzeichnet, dass** die Schaltungselemente zum Rücksetzen der Vorrichtung (1) ein steuerbares Schaltelement (24) aufweisen, mit dem ein Eingang der Integratoreinrichtung (10), insbesondere ein Eingang eines Ladungsdetektors der Integratoreinrichtung (10), temporär mit der Auswerteeinrichtung (20) verbindbar ist.

6. Verfahren zum Prüfen des Vorhandenseins einer elektrischen Gleichspannung als auch einer elektrischen Wechselspannung an einem möglicherweise spannungsführenden Teil (2) einer elektrischen Anlage, insbesondere zum Prüfen in Mittelspannungs- und/oder Hochspannungs-Energieversorgungsnetzen, unter Verwendung einer Vorrichtung (1) nach einem der voranstehenden Ansprüche, bei dem eine Kontaktelektrode (4) an das zu prüfende Teil (2) in Anlage gebracht wird oder eine Koppelelektrode an das zu prüfende Teil (2) angenähert wird, wobei mittels einer Integratoreinrichtung (10) das durch das In-Anlage-Bringen der Kontaktelektrode (4) oder durch das Annähern der Koppelelektrode sich verändernde elektrische Signal integriert wird, und wobei die Integratoreinrichtung (10) als Ladungsdetektor arbeitet, bei dem ein beim In-Anlage-Bringen der Kontaktelektrode (4) oder beim Annähern der Koppelelektrode fließender Ausgleichsstrom in einem Ladungsspeicher (18) gespeichert wird.

7. Verfahren nach Anspruch 6, **dadurch gekennzeichnet, dass** zum manuellen oder automatischen Rücksetzen der Integratoreinrichtung (10), insbesondere zum Entladen eines Ladungsspeichers (18) der Integratoreinrichtung (10), mindestens einmalig ein ansteigendes und anschließendes abfallendes Steuersignal an den Eingang der Integratoreinrichtung (10) angeschlossen wird.

8. Verfahren nach Anspruch 7, **dadurch gekennzeichnet, dass** nach einem Rücksetzen mit Hilfe des nochmaligen ansteigenden und anschließend abfallenden Steuersignals die ordnungsgemäße Trennung eines steuerbaren Schaltelements (24) überprüft wird.

## Claims

1. Device (1) for testing the presence of an electrical direct current voltage and also of an electrical alternating current voltage in a possibly live part (2) of an electrical system, with a contact electrode (4) which can be brought into contact with the part (2) to be tested or with a coupling electrode which can be brought close to the part to be tested, wherein the device (1) comprises an integrator device (10) for integrating the electrical signal which changes due to bringing the contact electrode (4) into contact or due to bringing the coupling electrode close, and wherein the integrator device (10) operates as a charge detector in which a compensating current flowing when the contact electrode (4) is brought into contact or when the coupling electrode is brought close can be stored in a charge storage device (18), **characterised in that** the device (1) is configured as a single-pole voltage tester, in particular for medium voltage and/or high voltage power supply networks, and thus detects whether direct current or alternating current voltage is applied to the part (2) to be tested, **in that** the output signal of the integrator device (10) is evaluated by means of an evaluation device (20) and it is decided by comparison with a threshold value whether the part (2) to be tested is live, **in that** at least one first threshold value for a direct current voltage applied to the part (2) to be tested and at least one second threshold value for an alternating current voltage applied to the part (2) to be tested is stored in the evaluation device (20) of the device (1), and **in that** the evaluation device (20) takes into account different threshold values depending on whether a direct current voltage or an alternating current voltage is applied to the part (2) to be tested.

2. Device (1) according to claim 1, **characterised in that** the integrator device (10) comprises an operational amplifier (16) in integrator circuit, with a charge storage device (18) connecting an output to an input of the operational amplifier (16) which stores the current flowing when the contact electrode (4) is brought into contact or when the coupling electrode is brought close.

3. Device (1) according to claim 1 or 2, **characterised in that**, after a decision of the evaluation device (20) that the part (2) to be tested is live, it is necessary to reset the integrator device (10), in particular to discharge a charge detector of the integrator device (10), before testing again.

4. Device (1) according to one of claims 1 to 3, **characterised in that** the device (1) comprises circuit elements for resetting the device (1), in particular for discharging a charge detector of the integrator device (10).

5. Device (1) according to claim 4, **characterised in that** the circuit elements for resetting the device (1) have a controllable switching element (24) with which an input of the integrator device (10), in particular an input of a charge detector of the integrator device (10), can be temporarily connected to the evaluation device (20).

6. Method for testing the presence of an electrical direct current voltage and also of an electrical alternating current voltage in a potentially live part (2) of an electrical system, in particular for testing in medium voltage and/or high voltage power supply networks, using a device (1) according to one of the preceding claims in which a contact electrode (4) is brought into contact with the part (2) to be tested or a coupling electrode is brought close to the part (2) to be tested, wherein the electrical signal which changes due to bringing the contact electrode (4) into contact or due to bringing the coupling electrode close is integrated by means of an integrator device (10), and wherein the integrator device (10) operates as a charge detector in which a compensating current flowing when the contact electrode (4) is brought into contact or when the coupling electrode is brought close is stored in a charge storage device (18).

7. Method according to claim 6, **characterised in that** for manually or automatically resetting the integrator device (10), in particular for discharging a charge storage device (18) of the integrator device (10), an increasing and subsequently decreasing control signal is connected at least once to the input of the integrator device (10).

8. Method according to claim 7, **characterised in that**, after a reset, proper disconnection of a controllable switching element (24) is checked with the aid of the control signal which increases again and subsequently decreases.

## Revendications

1. Système (1) de contrôle de la présence d'une tension électrique continue tout comme d'une tension électrique alternative sur une partie (2) éventuellement sous tension d'une installation électrique, comprenant une électrode (4) de contact, qui peut être mise en contact avec la partie (2) à contrôler, ou une électrode de couplage, qui peut être rapprochée de la partie à contrôler, dans lequel le système (1) a un dispositif (10) intégrateur pour l'intégration du signal électrique se modifiant par la mise en contact de l'électrode (4) de contact ou par le rapprochement de l'électrode de couplage, et dans lequel le dispositif (10) intégrateur travaille comme détecteur de charge, dans lequel un courant de compensation, passant lors de la mise en contact de l'électrode (4) de contact ou lors du rapprochement de l'électrode de couplage, peut être emmagasiné dans un accumulateur (18) de charge, **caractérisé en ce que** le système (1) est constitué sous la forme d'un contrôleur de tension unipolaire, notamment pour des réseaux d'alimentation en énergie en moyenne tension et/ou en haute tension, et détecte ainsi si une tension continue ou une tension alternative s'applique à la partie (2) à contrôler, **en ce qu'**au moyen d'un dispositif (20) d'évaluation le signal de sortie du dispositif (10) intégrateur est évalué et, par comparaison à une valeur de seuil, il est décidé si la partie (2) à contrôler est sous tension, **en ce que** dans le dispositif (20) d'évaluation du système (1) est mise en mémoire au moins une première valeur de seuil d'une tension continue s'appliquant à la partie (2) à contrôler et il est mis en mémoire au moins une deuxième valeur de seuil d'une tension alternative s'appliquant à la partie (2) à contrôler et **en ce que** le dispositif (20) d'évaluation prend en compte des valeurs de seuil différentes selon qu'une tension continue ou une tension alternative s'applique à la partie (2) à contrôler.

2. Système (1) suivant la revendication 1, **caractérisé en ce que** le dispositif (10) intégrateur a un amplificateur (16) opérationnel en circuit intégrateur, comprenant un accumulateur (18) de charge, qui relie une sortie à une entrée de l'amplificateur (16) opérationnel et qui accumule du courant passant lorsque l'électrode (4) de contact est mise en contact ou lorsque l'électrode de couplage se rapproche.

3. Système (1) suivant la revendication 1 ou 2, caractérisé en ce, après une décision du dispositif (20) d'évaluation, que la partie (2) à contrôler est sous tension, une remise à l'état initial du dispositif (10) intégrateur est nécessaire avant un nouveau contrôle, notamment une décharge du détecteur de charge du dispositif (10) intégrateur.

4. Système (1) suivant la revendication 1 à 3, **caractérisé en ce que** le système (1) a des éléments de circuit pour la remise à l'état initial du système (1), notamment pour la décharge d'un détecteur de charge du dispositif (10) intégrateur.

5. Système (1) suivant la revendication 4, **caractérisé en ce que** les éléments de circuit, pour la remise à l'état initial du système (1), ont un élément (24) de coupure, qui peut être commandé, par lequel une entrée du dispositif (10) intégrateur, notamment une entrée d'un détecteur de charge du dispositif (10) intégrateur, peut être reliée temporairement au dispositif (20) d'évaluation.

6. Procédé de contrôle de la présence d'une tension électrique continue tout comme d'une tension électrique alternative sur une partie éventuellement sous tension d'une installation électrique, notamment pour le contrôle dans des réseaux d'alimentation en énergie en moyenne tension et/ou en haute tension, en utilisant un système (1) suivant l'une des revendications précédentes, dans lequel on met une électrode (4) de contact en contact avec la partie (2) à contrôler ou on rapproche une électrode de couplage de la partie (2) à contrôler, dans lequel, au moyen d'un dispositif (10) intégrateur, on intègre le signal électrique, se modifiant par la mise en contact de l'électrode (4) de contact ou par le rapprochement de l'électrode de couplage, et dans lequel le dispositif intégrateur travaille en détecteur de charge, dans lequel on emmagasine, dans un accumulateur (18) de charge, un courant de compensation passant lorsque l'électrode (4) de contact est mise en contact ou lorsque l'électrode de couplage est rapprochée.

7. Procédé suivant la revendication 6, **caractérisé en ce que**, pour la remise à l'état initial manuelle ou automatique du dispositif (10) intégrateur, notamment pour la décharge d'un accumulateur (18) de charge du dispositif (10) intégrateur, on applique au moins une fois un signal de commande montant et ensuite descendant à l'entrée du dispositif (10) intégrateur.

8. Procédé suivant la revendication 7, **caractérisé en ce qu'**après une remise à l'état initial, à l'aide du signal de commande montant encore une fois et descendant ensuite, on contrôle la séparation en bon ordre d'un élément (24) de coupure pouvant être commandé.
